# EUROPÄISCHE PATENTSCHRIFT

(11) **EP 2 215 484 B1**
(45) Veröffentlichungstag und Bekanntmachung des Hinweises auf die Patenterteilung: **13.01.2016**
(21) Anmeldenummer: 08856131.1
(22) Anmeldetag: 27.10.2008
(51) Int. Cl.: G01R 1/067

(54) **TASTKOPF MIT HOCHGENAUER GLEICHSPANNUNGSMESSUNG**
PROBE WITH HIGHLY PRECISE DIRECT CURRENT MEASUREMENT
PALPEUR POUR MESURER TRÈS PRÉCISÉMENT UNE TENSION CONTINUE

(30) Priorität: 04.12.2007 DE 102007058338; 20.02.2008 DE 102008009962
(43) Veröffentlichungstag der Anmeldung: 11.08.2010
(73) Patentinhaber: Rohde & Schwarz GmbH & Co. KG, 81671 München (DE)
(72) Erfinder: REICHEL, Thomas, 85598 Baldham (DE); PESCHKE, Martin, 81549 München (DE)
(74) Vertreter: Körfer, Thomas
(86) Internationale Anmeldenummer: PCT/EP2008/009067
(87) Internationale Veröffentlichungsnummer: WO 2009/071156

(56) Entgegenhaltungen:
- WO-A2-2007/133980
- US-A- 4 403 183
- US-A- 5 034 698
- US-A- 5 384 532
- US-A1- 2005 185 769
- US-A1- 2007 267 213
- HAEUSER J: "PCI-HOSTED MEASUREMENT CARDS//TOWARDS THE COMPUTER-DRIVEN TEST LAB", ELEKTOR ELECTRONICS, ELEKTOR ELECTRONICS, GB, vol. 26, no. 292, 1 October 2000 (2000-10-01), pages 46-50, XP001076406, ISSN: 0268-4519

## Beschreibung

Die Erfindung betrifft einen Tastkopf zum Anschluss an Messgeräte, insbesondere an Oszilloskope, mit hochgenauer Gleichspannungsmessung.

Um mit den immer größer werdenden Bandbreiten moderner Bussysteme Schritt halten zu können, müssen auch moderne aktive Tastköpfe über immer größere Bandbreiten verfügen. Die dazu nötigen Verstärker müssen immer mehr in Richtung größerer Bandbreite (z.B. 5 GHz und mehr) optimiert werden. Statische Eigenschaften wie Gleichspannungsverstärkung und -Offset müssen den Forderungen nach größerer Bandbreite geopfert werden. Neben der Messung schneller Signale ist aber in der Praxis oft auch eine sehr genaue Messung von Gleichspannungen wünschenswert. Um Gleichspannungen möglichst genau messen zu können, ist es die gängige Praxis, den Tastkopf zunächst an ein Massepotential zu adaptieren und über die Positionseinstellung am Grundgerät den Gleichspannungs-Offset zu eliminieren. Danach kann die zu messende DC-Spannung offsetfrei bestimmt werden. Diese Methode ist aufwändig, eliminiert nicht den Verstärkungsfehler und kann bei Wechselspannungskopplung nicht angewandt werden. Wünschenswert wäre eine parallele, hochgenaue Gleichspannungsmessung, die unabhängig vom Messsignal angezeigt werden kann.

Mit aktuellen Breitbandtastköpfen für Oszilloskope können DC-Spannungen nur sehr ungenau gemessen werden, typischerweise mit einem Verstärkungsfehler von 2% und einem Offset von mehreren Millivolt. Dazu kommen noch der Fehler des Eingangswiderstands des Oszilloskops (typischerweise 1%), der Verstärkungsfehler des Eingangsverstärkers und des Analog-Digital-Wandlers im Oszilloskop (typischerweise 1%) und deren Offsets. Diese Fehler können zwar kalibriert werden, trotzdem ist die Gleichspannungsgenauigkeit unbefriedigend, da die Kalibrierung z.B. von Kanal, Temperatur und gewählter Verstärkung und Position abhängt. Außerdem können Nichtlinearitäten überhaupt nicht kalibriert werden.

So wird in der US 6,856,126 B2 ein herkömmlicher Tastkopf zur breitbandigen Messung von Hochfrequenz-Messsignalen gezeigt. Das Abgreifen des gesamten Signals erfolgt mit einer Tastspitze. Das gesamte Signal wird von demselben Verstärker verstärkt und von derselben Leitung an das Messgerät übertragen. Die geschilderten Probleme der ungenauen Gleichspannungsmessung treten sehr deutlich auf. Eine Kompensation von nichtlinearen Störungen der Gleichspannungsanteile ist nicht möglich.

US 5 034 698 A offenbart eine Messanordnung mit einer Tastspitze und einem Messgerät. Die Tastspitze trennt das Messsignal in ein Hochfrequenzmesssignal und ein Gleichspannungsmesssignal. Das Hochfrequenzmesssignal und das Gleichspannungsmesssignal werden durch unabhängige Verstärker in der Tastspitze vorverstärkt. Die verstärkten Messsignale werden jeweils über eine eigene Koaxialleitung und jeweils einen eigenen Messanschluss an das Messgerät übertragen und von diesem erfasst, digitalisiert und weiterverarbeitet.

Weitere Messsignalerfassungssysteme werden durch US 5 384 532 A, US 4 403 183 A, HAEUSER J: "PCI-HOSTED MEASUREMENT CARDS//TOWARDS THE COMPUTER-DRIVEN TEST LAB", ELEKTOR ELECTRONICS, GB, Bd. 26, Nr. 292, 1. Oktober 2000 (2000-10-01), Seiten 46-50, US 2005/185769 A1, US 2007/267213 A1 und WO 2007/133980 A2 offenbart.

Der Erfindung liegt die Aufgabe zu Grunde, eine Vorrichtung zu schaffen, welche eine hochgenaue gleichzeitige Messung von Gleichspannungsanteilen eines Signals neben der Messung von breitbandigen Frequenzanteilen ermöglicht und lediglich einen geringen Herstellungs- und Betriebsaufwand verursacht.

Die Aufgabe wird erfindungsgemäß für die Vorrichtung durch die Merkmale des unabhängigen Anspruchs 1 gelöst. Vorteilhafte Weiterbildungen sind Gegenstand der hierauf rückbezogenen Unteransprüche.

Ein Messsignalerfassungssystem verfügt über einen Tastkopf, eine erste Übertragungsleitung und ein Messgerät. Der Tastkopf ist mittels der ersten Übertragungsleitung mit dem Messgerät verbunden. Die erste Übertragungsleitung überträgt Breitband-Messsignale an das Messgerät. Das Messsignalerfassungssystem verfügt über zumindest eine weitere Übertragungsleitung. Der Tastkopf ist mittels der zumindest einen weiteren

Übertragungsleitung zumindest mittelbar mit dem Messgerät zusätzlich verbunden. Die zumindest eine weitere Übertragungsleitung überträgt Gleichspannungs-Messsignale an das Messgerät. So werden Gleichspannungs-Messsignale getrennt von den Breitband-Messsignalen an das Messgerät übertragen und gemessen. Eine Verringerung der Störungen und Messungenauigkeiten bei Gleichspannungs-Messsignalen ist so möglich.

Die zumindest eine Übertragungsleitung und die zumindest eine weitere Übertragungsleitung sind in einem gemeinsamen Hybridkabel geführt. So ist der Verkabelungsaufwand für das Bedienpersonal gering.

Der Tastkopf ist bevorzugt ein aktiver Tastkopf. So können besonders schwache Signale gemessen werden. Zusätzlich folgt ein günstiges Hochfrequenzverhalten.

Es ist ein Anschlussgehäuse mit einer Schnittstelle vorhanden. Der Tastkopf ist mit der ersten Übertragungsleitung und der zumindest einen weiteren Übertragungsleitung mechanisch verbunden. Die erste Übertragungsleitung und die zumindest eine weitere Übertragungsleitung sind mit dem Anschlussgehäuse mechanisch verbunden. Die Übertragungsleitungen sind mittels der Schnittstelle des Anschlussgehäuses an das Messgerät angeschlossen. So sind sämtliche Bauteile des Messsignalerfassungssystems sicher eingeschlossen und somit vor mechanischen Beschädigungen geschützt. Weiterhin ist eine Schirmung so einfach möglich.

Der Tastkopf beinhaltet bevorzugt einen Breitbandverstärker und einen Gleichspannungsverstärker. Durch die Verstärkung der Signale in dem Tastkopf werden einkoppelnde Störungen während der Übertragung vermieden.

Vorteilhafterweise sind Verstärkungsfaktoren des Breitbandverstärkers und des Gleichspannungsverstärkers unabhängig einstellbar. So können Signale mit unterschiedlich starken Signalkomponenten optimal vermessen werden.

Der Tastkopf beinhaltet bevorzugt zumindest eine Tastspitze, welche bevorzugt zumindest einen breitbandigen Anteil und zumindest einen Gleichspannungsanteil zumindest eines Signals aufnimmt. So ist der Aufbau des Tastkopfes günstig realisierbar. Ein zusätzlicher Aufwand durch mehrfaches Vorhalten der Tastspitzen für die verschiedenen Signalkomponenten wird so vermieden.

Der Tastkopf beinhaltet bevorzugt zumindest ein Teilernetzwerk, welches vorteilhafterweise aus zumindest einem seriellen ohmschen Widerstand und zumindest einem parallelen ohmschen Widerstand gegenüber Masse besteht. Bevorzugt ist die zumindest eine Tastspitze mit dem zumindest einen Teilernetzwerk verbunden. Vorteilhafterweise ist das zumindest eine Teilernetzwerk mit dem Breitbandverstärker verbunden. Durch den Einsatz eines Teilernetzwerks können zum einen starke Signale effizient gemessen werden. Weiterhin ist eine Impedanzanpassung des Tastkopfes so möglich.

Das Teilernetzwerk enthält zusätzlich bevorzugt eine Kapazität, welche parallel dem seriellen ohmschen Widerstand geschaltet ist. Das Teilernetzwerk enthält bevorzugt zusätzlich eine Kapazität gegenüber Masse, welche parallel dem parallelen ohmschen Widerstand geschaltet ist. Breitbandige Frequenzanteile des Messsignals laufen bevorzugt über die Kapazitäten. Gleichspannungsanteile des Messsignals laufen bevorzugt über die ohmschen Widerstände. So ist eine Trennung des breitbandigen Frequenzanteils von dem Gleichspannungsanteil möglich.

Der Gleichspannungsverstärker ist bevorzugt direkt oder über einen ohmschen Widerstand mit der zumindest einen Tastspitze oder mit dem zumindest einen parallelen ohmschen Widerstand oder direkt oder über einen ohmschen Widerstand mit dem dem Breitbandverstärker zugewandten Ende des Teilernetzwerks verbunden. Unterschiedliche Anschlussvarianten sind so möglich. Dies erhöht die fertigungstechnische Flexibilität und ermöglicht auf den individuellen Einsatzzweck abgestimmte Übertragungseigenschaften.

Der Gleichspannungsverstärker enthält vorteilhafterweise einen Operationsverstärker, einen ohmschen Widerstand und eine Kapazität. Der ohmsche Widerstand und die Kapazität sind vorteilhafterweise zwischen einen invertierenden Eingang und einen Ausgang des Operationsverstärkers geschaltet. Der Gleichspannungsverstärker ist vorteilhafterweise ein invertierender Verstärker und weist bevorzugt eine Tiefpass-Charakteristik auf. So wird die Trennung des breitbandigen Frequenzanteils und des Gleichspannungsanteils des Messsignals erreicht.

Das Anschlussgehäuse enthält zumindest einen Analog-Digital-Wandler, welcher an die zumindest eine weitere Übertragungsleitung angeschlossen ist. Das Anschlussgehäuse enthält einen Mikroprozessor, welcher an den zumindest einen Analog-Digital-Wandler angeschlossen ist. Der Mikroprozessor leitet ein digitales Ausgangssignal des zumindest einen Analog-Digital-Wandlers an das Messgerät weiter. So wird das Gleichspannungssignal bereits von dem Tastkopf gemessen. Eine Anpassung des Messgeräts an verschiedene Gleichspannungs-Messsignale ist nicht notwendig.

Der Mikroprozessor leitet das digitale Ausgangssignal des zumindest einen Analog-Digital-Wandlers über einen digitalen Datenbus an das Messgerät weiter. So kann das Messgerät über eine standardisierte Schnittstelle das Messergebnis des Gleichspannungssignals übernehmen.

Der Mikroprozessor mittelt bevorzugt das Gleichspannungssignal über ein bestimmtes Zeitintervall. Eine Erhöhung der Genauigkeit der Messung wird so erreicht. Kurzfristige Fluktuationen werden ausgeglichen.

Der Mikroprozessor führt bevorzugt eine Messwertkorrektur des Gleichspannungssignals durch. Die Qualität des Messergebnisses wird hierdurch weiter erhöht. Messfehler werden vor Erreichen des Messgeräts ausgefiltert.

Der Wert des von dem zumindest einen Analog-Digital-wandler digitalisierten Gleichspannungssignals stellt bevorzugt einen Verstärkungsfaktor und/oder ein Offset des Breitbandverstärkers in dem Tastkopf ein. So wird eine optimale Einstellung des Verstärkungsfaktors und/oder des Offsets anhand des sehr genauen Messergebnisses des Gleichspannungssignals erreicht.

Vorteilhafterweise verfügt das Messgerät über zumindest einen Eingangsverstärker und zumindest einen Analog-Digital-Wandler. Die zumindest eine Übertragungsleitung ist vorteilhafterweise an den zumindest einen Eingangsverstärker angeschlossen, welcher bevorzugt an den zumindest einen Analog-Digital-Wandler angeschlossen ist. Breitband-Messsignale werden vorteilhafterweise von dem zumindest einen Eingangsverstärker verstärkt und bevorzugt von dem zumindest einen Analog-Digital-Wandler digitalisiert. Der zumindest eine an die zumindest eine weitere Übertragungsleitung angeschlossene Analog-Digital-Wandler weist bevorzugt eine wesentlich geringere Höhe der Quantisierungsstufen auf als der zumindest eine in dem Messgerät befindliche Analog-Digital-Wandler. Weiterhin weist der zumindest eine an die zumindest eine weitere Übertragungsleitung angeschlossene Analog-Digital-Wandler bevorzugt eine wesentlich größere Verarbeitungszeit pro Messwert auf als der zumindest eine in dem Messgerät befindliche Analog-Digital-Wandler. So kann das Gleichspannungssignal mit wesentlich größerer Genauigkeit gegenüber dem Breitbandsignal gemessen werden. Durch den Einsatz langsamerer Komponenten kann dieser Qualitätsgewinn ohne einen größeren Aufwand des Aufbaus erreicht werden.

In einer weiteren Ausführung verfügt das Messsignalerfassungssystem bevorzugt über zwei weitere Übertragungsleitungen und bevorzugt über zwei Tastspitzen. Das Anschlussgehäuse verfügt bevorzugt über zwei Analog-Digital-Wandler. Ein differentielles Signal ist vorteilhafterweise mit dem Tastkopf abgreifbar und an das Messgerät übertragbar. Die Vermessung differentieller Signale getrennt nach Breitbandanteil und Gleichspannungsanteil ist so möglich.

Nachfolgend wird die Erfindung anhand der Zeichnung, in der vorteilhafte Ausführungsbeispiele der Erfindung dargestellt ist, beispielhaft beschrieben. In der Zeichnung zeigen:
- Fig. 1: ein Blockschaltbild eines ersten beispielhaften Tastkopfes;
- Fig. 2: ein Blockschaltbild eines ersten Ausführungsbeispiels des erfindungsgemäßen Tastkopfes;
- Fig. 3: einen Schaltplan eines zweiten Ausführungsbeispiels des erfindungsgemäßen Tastkopfes, und
- Fig. 4: ein Blockschaltbild eines dritten Ausführungsbeispiels des erfindungsgemäßen Tastkopfes.

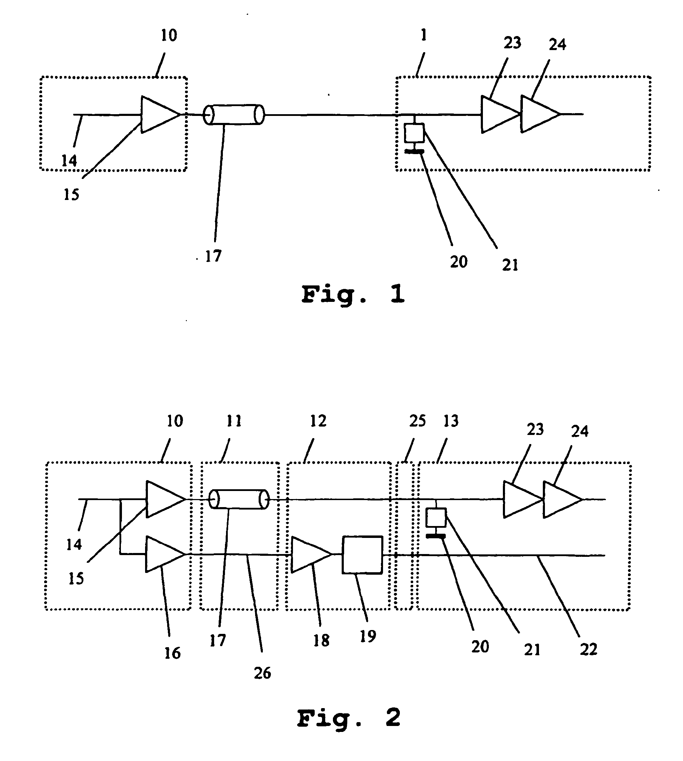

Zunächst wird anhand der Fig. 1 der Aufbau und die Funktionsweise eines herkömmlichen Tastkopfes erläutert. Mittels Fig. 2 - 4 wird der Aufbau und die Funktionsweise verschiedener Ausführungsbeispiele des erfindungsgemäßen Tastkopfes gezeigt. Identische Elemente werden in ähnlichen Abbildungen zum Teil nicht wiederholt dargestellt und beschrieben.

Fig. 1 zeigt ein Blockschaltbild eines ersten nicht erfindungsgemäßen Tastkopfes. Ein Tastkopf 10 besteht aus einer Tastspitze 14 und einem Breitbandverstärker 15. Dieser verstärkt Signale in einem sehr breiten Frequenzband. Der Tastkopf 10 ist mittels einer Übertragungsleitung 17 mit einem Messgerät 1 verbunden. Die Übertragungsleitung 17 ist als Koaxialleitung ausgeführt. Das Messgerät 1 ist beispielshalber ein Oszilloskop. Ein Einsatz von einem Spektrumanalysator oder einem anderen Messgerät ist ebenso möglich. Das Messgerät 1 verfügt über einen Eingangsverstärker 23 und einen Analog-Digital-Wandler 24. Weiterhin ist die Übertragungsleitung 17 innerhalb des Messgeräts mittels eines gegenüber Masse 20 geschalteten parallelen ohmschen Widerstands 21, von z.B. 50 Ohm, abgeschlossen.

Ein Signal wird von der Tastspitze 14 hochohmig abgegriffen und von dem Breitbandverstärker 15 gepuffert. Das gepufferte Signal wird von der Übertragungsleitung 17 an das Messgerät 1 übertragen. In dem Messgerät 1 wird das Signal von dem Eingangsverstärker 23 verstärkt, bevor es von dem Analog-Digital-Wandler 24 in ein digitales Signal gewandelt wird. Das digitale Signal kann nun weiterverarbeitet und angezeigt werden. Die Gleichspannungsmessfehler des Breitbandverstärkers 15, des Eingangsverstärkers 23 und des A/D-Wandlers 24, wie z.B. Offsetfehler, sind sehr groß, da es sich um breitbandige Komponenten handelt. Daher ist der Gleichspannungsmesswert der Anzeige mit einem großen Fehler beaufschlagt.

In Fig. 2 wird ein Blockschaltbild eines ersten Ausführungsbeispiels des erfindungsgemäßen Tastkopfes dargestellt. Ein Tastkopf 10 beinhaltet eine Tastspitze 14, einen Breitbandverstärker 15 und einen Gleichspannungsverstärker 16. Der Tastkopf 10 ist mit einem hybriden Kabel 11 verbunden. Das hybride Kabel 11 beinhaltet eine Übertragungsleitung 17 zur Übertragung von Breitband-Messsignalen und eine Übertragungsleitung 26 zur Übertragung von Gleichspannungs-Messsignalen. Breitband-Messsignale sind dabei Messsignale, welche über Signalanteile in einem sehr breiten Frequenzband verfügen können. Das hybride Kabel 11 ist mittels eines Anschlussgehäuses 12 an ein Messgerät 13 angeschlossen. Das Anschlussgehäuse 12 beinhaltet einen Analog-Digital-Wandler 18 und einen Mikroprozessor 19. Der Mikroprozessor 19 ist über eine Schnittstelle 25 mit einem digitalen Bus 22 innerhalb des Messgeräts 13 verbunden. Dieser digitale Bus könnte z.B. ein universeller serieller Bus (USB) sein. Die Übertragungsleitung 17 ist über das Anschlussgehäuse 12 mit einem Eingangsverstärker 23 und einem Analog-Digital-Wandler 24 innerhalb des Messgeräts 13 verbunden. Alternativ kann auf den Analog-Digital-Wandler 18 und den Mikroprozessor 19 verzichtet werden. Die Übertragungsleitung 26 ist dann direkt über die Schnittstelle mit dem Messgerät 13 verbunden. Die von dem Gleichspannungsverstärker 16 verstärkten Gleichspannungssignale werden dann ohne weitere Verarbeitung an das Messgerät 13 weitergeleitet. Es werden ein interner Verstärker und ein interner Analog-Digital-Wandler zur Weiterverarbeitung des Signals eingesetzt.

Ein Signal wird von der Tastspitze 14 hochohmig abgegriffen und in einen Breitbandanteil und einen Gleichspannungsanteil getrennt. Der Breitbandanteil beinhaltet dabei Signalanteile, welche ein sehr breites Signal-Spektrum enthalten können. Der Breitbandanteil wird von dem Breitbandverstärker 15 gepuffert und über die Übertragungsleitung 17 in dem hybriden Kabel 11 über das Anschlussgehäuse 12 an das Messgerät 13 übertragen. Der Gleichspannungsanteil des Signals wird von dem Gleichspannungsverstärker 16 verstärkt und über die Übertragungsleitung 26 in dem hybriden Kabel 11 an das Anschlussgehäuse 12 übertragen. Dort wird es von dem Analog-Digital-Wandler 18 in ein digitales Signal gewandelt. Da die Ausgangsspannung des Gleichspannungsverstärkers 16 hochohmig abgegriffen wird, entfällt die Toleranz der Ein- und Ausgangswiderstände der Übertragungsleitung 17 im Breitband-Pfad. Der Breitband-Pfad bezeichnet hier den für die Messung von breitbandigen Signalen ausgelegten Signal-Pfad. Ferner können langsame und hochgenaue Elemente als Puffer und Wandler eingesetzt werden, wodurch Offsets und Verstärkungsfehler des Breitbandverstärkers 23 und Analog-Digital-Wandlers 24 entfallen.

Der Mikroprozessor 19 führt eine Mittelung und/oder eine Messwertkorrektur an dem Signal durch. Über die Schnittstelle 25 und den digitalen Bus 22 übermittelt der Mikroprozessor 19 das digitale nachverarbeitete Signal an das Messgerät 13. Bei der Messwertkorrektur können auch nicht lineare Zusammenhänge von Ein- und Ausgangsspannung und Temperaturabhängigkeiten des genauen Gleichspannungspfades berücksichtigt werden, was bei einer Korrektur der breitbandigen anfallenden Messdaten im Grundgerät so nicht möglich ist. Der Breitbandverstärker 23 in dem Messgerät 13 verstärkt das Breitbandsignal noch einmal bevor es von dem Analog-Digital-Wandler 24 in ein digitales Signal gewandelt wird. Die beiden digitalen Signale können nun weiterverarbeitet und angezeigt werden.

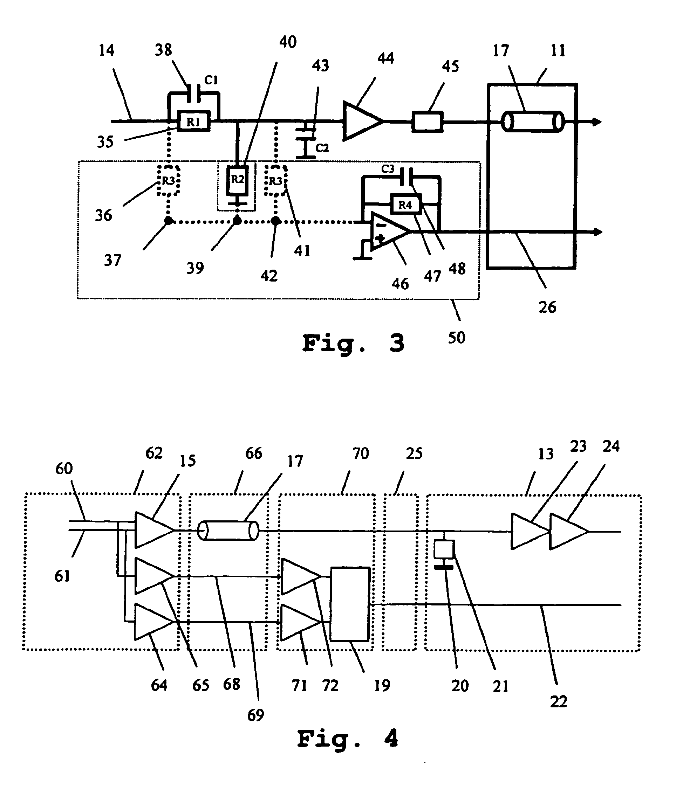

Fig. 3 zeigt einen Schaltplan eines zweiten Ausführungsbeispiels des erfindungsgemäßen Tastkopfes. Die Tastspitze 14 ist an einen kompensierten RC-Teiler bestehend aus Widerständen 35, 40 (Rl, R2) und Kapazitäten 38, 43 (C1, C2) angeschlossen. Der Gleichspannungsverstärker 50 ist als Operationsverstärker 46 in invertierender Beschaltung ausgeführt. Die Widerstände 36 (R3) bzw. 40 (R2) bzw. 41 (R3) und 47 (R4) und die Kapazität 48 (C3) bilden diese invertierende Beschaltung. Falls der Anschluss des Gleichspannungsverstärkers 50 über den Widerstand 40 (R2) erfolgt ist dieser sowohl Teil des Spannungsteilers des Breitbandverstärkers als auch Teil des Gleichspannungsverstärkers 50. Ist der Gleichspannungsverstärker 50 über einen der Widerstände 36 (R3) oder 41 (R3) angeschlossen, so ist der Widerstand 40 (R2) nicht Teil des Gleichspannungsverstärkers 50. Der Vorteil einer invertierenden Schaltung besteht darin, dass die Spannung direkt massebezogen gemessen werden kann. Zusätzlich ist durch den Rückkoppelkondensator 48 (C3) eine Tiefpass-Charakteristik des Gleichspannungsverstärkers 50 realisiert. Die virtuelle Masse, die am negativen Eingang des Operationsverstärkers 46 entsteht sorgt zusammen mit dem Rückkoppelkondensator 48 (C3) dafür, dass die typischerweise große Eingangskapazität des hochgenauen Operationsverstärkers den Frequenzgang nicht verfälscht.

Außerdem erleichtert diese Schaltung eine Ausführung des Operationsverstärkers als Chopper- oder Auto-Zero-Verstärker, da elektronische Schalter am Verstärkereingang keinen hohen Eingangsspannungsbereich aufweisen müssen. Bei sehr hohen Frequenzen fließt der Strom ausschließlich über den kapazitiven Teiler 38, 43 (C1, C2). Der Breitbandverstärker 44 ist lediglich schematisch dargestellt und hat einen Ausgangswiderstand 45 von 50 Ohm. Der Abgriff für den Gleichspannungsverstärker, hier den invertierend beschalteten Operationsverstärker 46, kann an dem Anschluss 37, vor dem Teiler erfolgen. In diesem Fall wird der Operationsverstärker über den Widerstand 36 (R3) angeschlossen. Den Anschluss kann alternativ an dem Anschluss 39 am Teilerfußpunkt erfolgen. In diesem Fall entfällt der dortige Masseanschluss. Weiterhin kann der Anschluss am Anschluss 42, am Teilermittelpunkt erfolgen. In diesem Fall erfolgt der Anschluss über den Widerstand 41 (R3).

Die Werte der Bauelemente betragen typischerweise ca. C1 = 0,5 pF und C2 = 2 pF. Im Fall des Anschlusses der Operationsverstärkers vor dem Teiler sind in etwa R1 = 1600 kOhm, R2 = 400 kOhm, R3 = 2000 kOhm, R4 = 200 kOhm. Im Fall des Anschlusses am Teilerfußpunkt sind in etwa R1 = 800 kOhm, R2 = 200 kOhm, R4 = 100 kOhm. Im Fall des Anschlusses am Teilermittelpunkt sind in etwa R1 = 800 kOhm, R2 = 250 kOhm, R3 = 1000 kOhm, R4 = 500 kOhm für eine 10:1 Teilung in beiden Pfaden. Der Widerstand 45 ist der Ausgangswiderstand (bevorzugt 50 Ohm) der Übertragungsleitung 17. Die 10:1 Teilung im Breitband-Pfad kommt durch einen Teilungsfaktor von 1:5 für den Breitband-Pfad bis zu dem Breitband-Verstärker 44 und einen weiteren Teilungsfaktor von 1:2, welcher durch den Ausgangswiderstand 45 und einen nicht dargestellten Abschlusswiderstand von 50 Ohm entsteht, zustande. Das Gleichspannungssignal wird über eine in dem hybriden Kabel befindliche Leitung 26 übertragen.

In Fig. 4 wird ein Blockschaltbild eines dritten Ausführungsbeispiels des erfindungsgemäßen Tastkopfes gezeigt. Ein Tastkopf 62 beinhaltet zwei Tastspitzen 60, 61, einen Breitbandverstärker 15 und zwei Gleichspannungsverstärker 64, 65. Der Tastkopf 62 ist mit einem hybriden Kabel 66 verbunden. Das hybride Kabel 66 beinhaltet eine Übertragungsleitung 17 zur Übertragung von Breitband-Messsignalen und zwei Übertragungsleitungen 68, 69 zur Übertragung von Gleichspannungs-Messsignalen. Das hybride Kabel 66 ist mittels eines Anschlussgehäuses 70 an ein Messgerät 13 angeschlossen. Das Anschlussgehäuse 70 beinhaltet zwei Analog-Digital-Wandler 71, 72 und einen Mikroprozessor 19. Der Mikroprozessor 19 ist mit einen digitalen Bus 22 innerhalb des Messgeräts 13 verbunden. Die Übertragungsleitung 17 ist über das Anschlussgehäuse 70 mit einem Breitbandverstärker 23 und einem Analog-Digital-Wandler 24 innerhalb des Messgeräts 13 verbunden.

Ein differentielles Signal wird von den Tastspitzen 60, 61 hochohmig abgegriffen und in ein Breitbandanteil und einen Gleichspannungsanteil getrennt. Der Breitbandanteil wird von dem Breitbandverstärker 15 gepuffert und über die Übertragungsleitung 17 in dem hybriden Kabel 66 über das Anschlussgehäuse 70 an das Messgerät 13 übertragen. Der Gleichspannungsanteil des Signals wird von den Gleichspannungsverstärkern 64, 65 verstärkt und über die Übertragungsleitungen 68, 69 in dem hybriden Kabel 66 an das Anschlussgehäuse 70 übertragen. Dort wird es von den Analog-Digital-Wandlern 71, 72 in digitale Signale gewandelt. Da die Ausgangsspannung der Gleichspannungsverstärker 64, 65 hochohmig abgegriffen wird, entfällt die Toleranz der Ein- und Ausgangswiderstände der Übertragungsleitung 17 im Breitband-Pfad. Ferner können langsame und hochgenaue Elemente als Puffer und Wandler eingesetzt werden, wodurch Offsets und Verstärkungsfehler des Breitbandverstärkers 23 und Analog-Digital-Wandler 24 entfallen.

Der Mikroprozessor 19 führt eine Mittelung und/oder eine Messwertkorrektur an den Signalen durch. Über den digitalen Bus 22 übermittelt der Mikroprozessor 19 die digitalen nachverarbeiteten Signale an das Messgerät 13. Bei der Messwertkorrektur können auch nicht lineare Zusammenhänge von Ein- und Ausgangsspannung und Temperaturabhängigkeiten der genauen Gleichspannungspfade berücksichtigt werden, was bei einer Korrektur der breitbandigen anfallenden Messdaten im Messgerät 13 so nicht möglich ist. Der Breitbandverstärker 23 in dem Messgerät 13 verstärkt das Breitbandsignal noch einmal bevor es von dem Analog-Digital-Wandler 24 in ein digitales Signal gewandelt wird. Die drei digitalen Signale können nun weiterverarbeitet und angezeigt werden. Alternativ zu den beiden Verstärkern 64, 65 und Leitungen 68, 69 kann auch ein einzelner differentieller Verstärker mit einer einzelnen differentiellen Leitung eingesetzt werden.

Die Erfindung ist nicht auf das dargestellte Ausführungsbeispiel beschränkt. Wie bereits erwähnt, können weitere unterschiedliche Signalarten über eine beliebige Anzahl an Tastspitzen aufgenommen und über eine beliebige Anzahl an Leitungen übertragen werden. Auch ist ein Einsatz unterschiedlicher Verstärker, z.B. in nichtinvertierender Bauweise möglich. Alle vorstehend beschriebenen Merkmale oder in den Figuren gezeigten Merkmale sind im Rahmen der Erfindung beliebig miteinander kombinierbar.

## Patentansprüche

1. Messsignalerfassungssystem mit einem Tastkopf (10, 62), mit zumindest einer ersten Übertragungsleitung (17) und einem Messgerät (13),
wobei der Tastkopf mittels der ersten Übertragungsleitung (17) mit dem Messgerät (13) verbunden ist,
wobei die erste Übertragungsleitung (17) dazu eingerichtet ist, Breitband-Messsignale an das Messgerät (13) zu übertragen,
wobei das Messsignalerfassungssystem über zumindest eine weitere Übertragungsleitung (26, 68, 69) verfügt,
wobei der Tastkopf mittels der zumindest einen weiteren Übertragungsleitung (26, 68, 69) mit dem Messgerät (13) zusätzlich zumindest mittelbar verbunden ist,
wobei die zumindest eine weitere Übertragungsleitung (26, 68, 69) dazu eingerichtet ist, Gleichspannungs-Messsignale an das Messgerät (13) zu übertragen, und
wobei der Tastkopf (10, 62) mit der ersten Übertragungsleitung (17) und der zumindest einen weiteren Übertragungsleitung (26, 68, 69) mechanisch verbunden ist,
**dadurch gekennzeichnet,**
**dass** ein Anschlussgehäuse (12, 70) mit einer Schnittstelle (25) zum Messgerät (13) vorhanden ist,
**dass** die erste Übertragungsleitung (17) und die zumindest eine weitere Übertragungsleitung (26, 68, 69) mit dem Anschlussgehäuse (12, 70) mechanisch verbunden sind,
**dass** die Übertragungsleitungen (17, 26, 68, 69) mittels der Schnittstelle (25) des Anschlussgehäuses (12, 70) an das Messgerät (13) angeschlossen sind,
**dass** das Anschlussgehäuse (12, 70) zumindest einen Analog-Digital-Wandler (18, 71, 72) enthält,
**dass** die zumindest eine weitere Übertragungsleitung (26, 68, 69) an den zumindest einen Analog-Digital-Wandler (18, 71, 72) angeschlossen ist,
**dass** die erste Übertragungsleitung (17) und die zumindest eine weitere Übertragungsleitung (26, 68, 69) in einem gemeinsamen Hybridkabel (11, 66) geführt sind,
**dass** das Anschlussgehäuse (12, 70) einen Mikroprozessor (19) enthält,
**dass** der Mikroprozessor (19) an den zumindest einen Analog-Digital-Wandler (18, 71, 72) angeschlossen ist, und dass der Mikroprozessor (19) dazu eingerichtet ist, ein digitales Ausgangssignal des zumindest einen Analog-Digital-Wandlers (18, 71, 72) über einen digitalen Datenbus (22) an das Messgerät (13) weiterzuleiten.

2. Messsignalerfassungssystem nach Anspruch 1,
**dadurch gekennzeichnet,**
**dass** der Tastkopf ein aktiver Tastkopf ist.

3. Messsignalerfassungssystem nach Anspruch 1 oder 2,
**dadurch gekennzeichnet,**
**dass** der Tastkopf (10, 62) einen Breitbandverstärker (15, 44) und einen Gleichspannungsverstärker (16, 50, 64, 65) beinhaltet.

4. Messsignalerfassungssystem nach Anspruch 3,
**dadurch gekennzeichnet,**
**dass** Verstärkungsfaktoren des Breitbandverstärkers (15, 44) und des Gleichspannungsverstärkers (16, 50, 64, 65) unabhängig einstellbar sind.

5. Messsignalerfassungssystem nach Anspruch 3 oder 4,
**dadurch gekennzeichnet,**
**dass** der Tastkopf (10, 62) zumindest eine Tastspitze (14, 60, 61) beinhaltet, und
**dass** die Tastspitze (14, 60, 61) zumindest einen breitbandigen Anteil und zumindest einen Gleichspannungsanteil des Messsignals aufnimmt.

6. Messsignalerfassungssystem nach Anspruch 5,
**dadurch gekennzeichnet,**
**dass** der Tastkopf (10, 62) zumindest ein Teilernetzwerk beinhaltet,
**dass** das zumindest eine Teilernetzwerk aus zumindest einem seriellen ohmschen Widerstand (35) und zumindest einem parallelen ohmschen Widerstand (40) gegenüber Masse besteht, und
**dass** die zumindest eine Tastspitze (14, 60, 61) mit dem zumindest einen Teilernetzwerk verbunden ist, und
**dass** das zumindest eine Teilernetzwerk mit dem Breitbandverstärker (15, 44) verbunden ist.

7. Messsignalerfassungssystem nach Anspruch 6,
**dadurch gekennzeichnet,**
**dass** das Teilernetzwerk zusätzlich eine Kapazität (38), welche parallel dem seriellen ohmschen Widerstand (35) geschaltet ist, enthält,
**dass** das Teilernetzwerk zusätzlich eine Kapazität (43) gegenüber Masse, welche parallel dem parallelen ohmschen Widerstand (40) geschaltet ist, enthält,
**dass** breitbandige Frequenzanteile des Messsignals über die Kapazitäten (38, 43) laufen, und
**dass** Gleichspannungsanteile des Messsignals über die ohmschen Widerstände (35, 40) laufen.

8. Messsignalerfassungssystem nach Anspruch 6 oder 7,
**dadurch gekennzeichnet,**
**dass** der Gleichspannungsverstärker (16, 50, 64, 65) direkt oder über einen ohmschen Widerstand (36) mit der Tastspitze (14, 60, 61) verbunden ist.

9. Messsignalerfassungssystem nach Anspruch 6 oder 7,
**dadurch gekennzeichnet,**
**dass** der Gleichspannungsverstärker (16, 50, 64, 65) mit dem zumindest einen parallelen ohmschen Widerstand (40) verbunden ist.

10. Messsignalerfassungssystem nach Anspruch 6 oder 7,
**dadurch gekennzeichnet,**
**dass** der Gleichspannungsverstärker (16, 50, 64, 65) direkt oder über einen ohmschen Widerstand (41) mit dem dem Breitbandverstärker (15, 44) zugewandten Ende des Teilernetzwerks verbunden ist.

11. Messsignalerfassungssystem nach einem der Ansprüche 3 bis 10,
**dadurch gekennzeichnet,**
**dass** der Gleichspannungsverstärker (16, 50, 64, 65) einen Operationsverstärker (46), einen ohmschen Widerstand (47) und eine Kapazität (48) enthält,
**dass** der ohmsche Widerstand (47) und die Kapazität (48) zwischen einen invertierenden Eingang und einen Ausgang des Operationsverstärkers (46) geschaltet sind,
**dass** der Gleichspannungsverstärker (16, 50, 64, 65) ein invertierender Verstärker ist, und
**dass** der Gleichspannungsverstärker (16, 50, 64, 65) eine Tiefpass-Charakteristik aufweist.

12. Messsignalerfassungssystem nach einem der Ansprüche 1 bis 11,
**dadurch gekennzeichnet,**
**dass** der Mikroprozessor (19) das Gleichspannungssignal über ein bestimmtes Zeitintervall mittelt.

13. Messsignalerfassungssystem nach einem der Ansprüche 1 bis 12,
**dadurch gekennzeichnet,**
**dass** der Mikroprozessor (19) eine Messwertkorrektur des Gleichspannungssignals durchführt.

14. Messsignalerfassungssystem nach einem der Ansprüche 1 bis 13,
**dadurch gekennzeichnet,**
**dass** der Wert des von dem zumindest einen Analog-Digital-Wandler (18, 71, 72) digitalisierten Gleichspannungssignals einen Verstärkungsfaktor und/oder einen Offset des Breitbandverstärkers (15, 44) in dem Tastkopf (10, 62) einstellt.

15. Messsignalerfassungssystem nach einem der Ansprüche 5 bis 10,
**dadurch gekennzeichnet,**
**dass** das Messgerät (13) über zumindest einen Eingangsverstärker (23) und zumindest einen Analog-Digital-Wandler (24) verfügt,
**dass** die erste Übertragungsleitung (17) an den zumindest einen Eingangsverstärker (23) angeschlossen ist,
**dass** der Eingangsverstärker (23) an den Analog-Digital-Wandler (24) angeschlossen ist,
**dass** Breitband-Messsignale von dem Eingangsverstärker (23) verstärkt werden,
**dass** verstärkte Breitband-Messsignale von dem Analog-Digital-Wandler (24) digitalisiert werden,
**dass** der an die weitere Übertragungsleitung (26, 68, 69) angeschlossene Analog-Digital-Wandler (18, 71, 72) eine wesentlich geringere Höhe der Quantisierungsstufen aufweist als der in dem Messgerät (13) befindliche Analog-Digital-Wandler (24) für das Breitband-Messsignal, und dass der an die weitere Übertragungsleitung (26, 68, 69) angeschlossene Analog-Digital-Wandler (18, 71, 72) eine wesentlich größere Verarbeitungszeit pro Messwert aufweist als der Analog-Digital-Wandler (24) für das Breitband-Messsignal.

16. Messsignalerfassungssystem nach einem der Ansprüche 5 bis 10 oder 15,
**dadurch gekennzeichnet,**
**dass** das Messsignalerfassungssystem über zwei weitere Übertragungsleitungen (68, 69) verfügt,
**dass** der Tastkopf über zwei Tastspitzen (60, 61) verfügt, dass das Anschlussgehäuse (70) über zwei Analog-Digital-Wandler (71, 72) für das Gleichspannungs-Messsignal verfügt,
**dass** ein differentielles Signal mit dem Tastkopf abgreifbar und an das Messgerät (13) übertragbar ist.

## Claims

1. Measurement signal acquisition system with a probe (10, 62), with at least one first transmission line (17) and a measuring device (13),
wherein the probe is connected with the measuring device (13) by means of the first transmission line (17), wherein the first transmission line (17) is configured to transmit broadband measurement signals to the measuring device (13),
wherein the measurement signal acquisition system has at least one further transmission line (26, 68, 69), wherein the probe is additionally at least indirectly connected by means of the at least one further transmission line (26, 68, 69) with the measuring device (13),
wherein the at least one further transmission line (26, 68, 69) is configured to transmit direct current voltage measurement signals to the measuring device (13), and wherein the probe (10, 62) is connected mechanically with the first transmission line (17) and the at least one further transmission line (26, 68, 69),
**characterised in that**
a connection housing (12, 70) with an interface (25) to the measuring device (13) is present,
**in that** the first transmission line (17) and the at least one further transmission line (26, 68, 69) are connected mechanically with the connection housing (12, 70),
**in that** the transmission lines (17, 26, 68, 69) are connected to the measuring device (13) by means of the interface (25) of the connection housing (12, 70),
**in that** the connection housing (12, 70) comprises at least one analogue-digital converter (18, 71, 72),
**in that** the at least one further transmission line (26, 68, 69) is connected to the at least one analogue-digital converter (18, 71, 72),
**in that** the first transmission line (17) and the at least one further transmission line (26, 68, 69) are carried in a common hybrid cable (11, 66),
**in that** the connection housing (12, 70) comprises a microprocessor (19),
**in that** the microprocessor (19) is connected to the at least one analogue-digital converter (18, 71, 72), and **in that** the microprocessor (19) is configured to forward a digital output signal of the at least one analogue-digital converter (18, 71, 72) via a digital data bus (22) to the measuring device (13).

2. Measurement signal acquisition system according to claim 1,
**characterised in that**
the probe is an active probe.

3. Measurement signal acquisition system according to claim 1 or 2,
**characterised in that**
the probe (10, 62) comprises a broadband amplifier (15, 44) and a direct current voltage amplifier (16, 50, 64, 65) .

4. Measurement signal acquisition system according to claim 3,
**characterised in that**
amplification factors of the broadband amplifier (15, 44) and the direct current voltage amplifier (16, 50, 64, 65) can be set independently.

5. Measurement signal acquisition system according to claim 3 or 4,
**characterised in that**
the probe (10, 62) comprises at least one probe tip (14, 60, 61), and
**in that** the probe tip (14, 60, 61) receives at least one broadband part and at least one direct current voltage part of the measurement signal.

6. Measurement signal acquisition system according to claim 5,
**characterised in that**
the probe (10, 62) comprises at least one divider network,
**in that** the at least one divider network consists of at least one serial ohmic resistor (35) and at least one parallel ohmic resistor (40) to ground, and
**in that** the at least one probe tip (14, 60, 61) is connected with the at least one divider network, and
**in that** the at least one divider network is connected with the broadband amplifier (15, 44).

7. Measurement signal acquisition system according to claim 6,
**characterised in that**
the divider network additionally comprises a capacitor (38) which is connected parallel to the serial ohmic resistor (35),
**in that** the divider network additionally comprises a capacitor (43) to ground, which is connected parallel to the parallel ohmic resistor (40),
**in that** broadband frequency parts of the measurement signal run via the capacitors (38, 43), and
**in that** direct current voltage parts of the measurement signal run via the ohmic resistors (35, 40).

8. Measurement signal acquisition system according to claim 6 or 7,
**characterised in that**
the direct current voltage amplifier (16, 50, 64, 65) is connected directly or via an ohmic resistor (36) with the probe tip (14, 60, 61).

9. Measurement signal acquisition system according to claim 6 or 7,
**characterised in that**
the direct current voltage amplifier (16, 50, 64, 65) is connected with the at least one parallel ohmic resistor (40).

10. Measurement signal acquisition system according to claim 6 or 7,
**characterised in that**
the direct current voltage amplifier (16, 50, 64, 65) is connected directly or via an ohmic resistor (41) with the end of the divider network facing the broadband amplifier (15, 44).

11. Measurement signal acquisition system according to one of claims 3 to 10,
**characterised in that**
the direct current voltage amplifier (16, 50, 64, 65) comprises an operation amplifier (46), an ohmic resistor (47) and a capacitor (48),
**in that** the ohmic resistor (47) and the capacitor (48) are switched between an inverting input and an output of the operation amplifier (46),
**in that** the direct current voltage amplifier (16, 50, 64, 65) is an inverting amplifier, and
**in that** the direct current voltage amplifier (16, 50, 64, 65) exhibits a low pass characteristic.

12. Measurement signal acquisition system according to one of claims 1 to 11,
**characterised in that**
the microprocessor (19) averages the direct current voltage signal over a certain interval of time.

13. Measurement signal acquisition system according to one of claims 1 to 12,
**characterised in that**
the microprocessor (19) carries out a measurement value correction of the direct current voltage signal.

14. Measurement signal acquisition system according to one of claims 1 to 13,
**characterised in that**
the value of the direct current voltage signal digitised by the at least one analogue-digital converter (18, 71, 72) sets an amplification factor and/or an offset of the broadband amplifier (15, 44) in the probe (10, 62).

15. Measurement signal acquisition system according to one of claims 5 to 10,
**characterised in that**
the measuring device (13) has at least one input amplifier (23) and at least one analogue-digital converter (24),
**in that** the first transmission line (17) is connected to the at least one input amplifier (23),
**in that** the input amplifier (23) is connected to the analogue-digital converter (24),
**in that** broadband measurement signals are amplified by the input amplifier (23),
**in that** amplified broadband measurement signals are digitised by the analogue-digital converter (24),
**in that** the analogue-digital converter (18, 71, 72) connected to the further transmission line (26, 68, 69) exhibits a substantially lower level of quantization stages than the analogue-digital converter (24) for the broadband measurement signal located in the measuring device (13), and
**in that** the analogue-digital converter (18, 71, 72) connected to the further transmission line (26, 68, 69) exhibits a much greater processing time per measurement value than the analogue-digital converter (24) for the broadband measurement signal.

16. Measurement signal acquisition system according to one of claims 5 to 10 or 15,
**characterised in that**
the measurement signal acquisition system has two further transmission lines (68, 69),
**in that** the probe has two probe tips (60, 61),
**in that** the connection housing (70) has two analogue-digital converters (71, 72) for the direct current voltage measurement signal,
**in that** a differential signal can be tapped with the probe and transmitted to the measuring device (13).

## Revendications

1. Système de détection de signaux de mesure comportant un palpeur (10, 62), comportant au moins une première ligne de transmission (17) et un appareil de mesure (13),
dans lequel le palpeur est relié à l'appareil de mesure (13) au moyen de la première ligne de transmission (17).
dans lequel la première ligne de transmission (17) est configurée pour transmettre des signaux de mesure à large bande à l'appareil de mesure (13),
dans lequel le système de détection de signaux de mesure dispose d'au moins une autre ligne de transmission (26, 68, 69),
dans lequel le palpeur est relié de plus au moins directement à l'appareil de mesure (13) au moyen d'au moins une autre ligne de transmission (26, 68, 69),
dans lequel la au moins une autre ligne de transmission (26, 68, 69) est configurée pour transmettre des signaux de mesure de tension continue à l'appareil de mesure (13), et
dans lequel le palpeur (10, 62) est relié mécaniquement à la première ligne de transmission (17) et à la au moins une autre ligne de transmission (26, 68, 69),
**caractérisé en ce que**
un boîtier de connexion (12, 70) comportant une interface (25) est prévu dans l'appareil de mesure (13),
**en ce que** la première ligne de transmission (17) et la au moins une autre ligne de transmission (26, 68, 69) sont reliées mécaniquement au boîtier de connexion (12, 70),
**en ce que** les lignes de transmission (17, 26, 68, 69) sont reliées à l'appareil de mesure (13) grâce à l'interface (25) du boîtier de connexion (12, 70),
**en ce que** le boîtier de connexion (12, 70) comporte au moins un transducteur analogique-numérique (18, 71, 72),
**en ce que** la au moins une autre ligne de transmission (26, 68, 69) est reliée au au moins un transducteur analogique-numérique (18, 71, 72),
**en ce que** la première ligne de transmission (17) et la au moins une autre ligne de transmission (26, 68, 69) sont guidées dans un câble hybride commun (11, 66),
**en ce que** le boîtier de connexion (12, 70) comporte un microprocesseur (19),
**en ce que** le microprocesseur (19) est relié au au moins un transducteur analogique-numérique (18, 71, 72), et
**en ce que** le microprocesseur (19) est configuré pour transmettre un signal de sortie numérique du au moins un transducteur analogique-numérique (18, 71, 72) à l'appareil de mesure (13) par l'intermédiaire d'un bus de données numérique (22).

2. Système de détection de signaux de mesure selon la revendication 1, **caractérisé en ce que**
le palpeur est un palpeur actif.

3. Système de détection de signaux de mesure selon la revendication 1 ou 2, **caractérisé en ce que**
le palpeur (10, 62) comporte un amplificateur à large bande (15, 44) et un amplificateur à tension continue (16, 50, 64, 65).

4. Système de détection de signaux de mesure selon la revendication 3, **caractérisé en ce que**
des facteurs d'amplification de l'amplificateur à large bande (15, 44) et de l'amplificateur à tension continue (16, 50, 60 4 65) peuvent être réglés de façon indépendante.

5. Système de détection de signaux de mesure selon la revendication 3 ou 4, **caractérisé en ce que**
le palpeur (10, 62) comporte au moins une pointe de palpage (14, 60, 61), et
**en ce que** la pointe de palpage (14, 60, 61) reçoit au moins une partie à large bande et au moins une partie de tension continue du signal de mesure.

6. Système de détection de signaux de mesure selon la revendication 5, **caractérisé en ce que**
le palpeur (10, 62) comporte au moins un réseau diviseur,
**en ce que** le au moins un réseau diviseur est constitué d'au moins une résistance ohmique série (35) et au moins une résistance ohmique parallèle (40) par rapport à la masse, et
**en ce que** la au moins une pointe de palpage (14, 60, 61) est reliée à au moins un réseau diviseur, et
**en ce que** le au moins un réseau diviseur est relié à l'amplificateur à large bande (15, 44).

7. Système de détection de signaux de mesure selon la revendication 6, **caractérisé en ce que**
le réseau diviseur comporte de plus une capacité (38), qui est montée en parallèle à la résistance ohmique série (35),
**en ce que** le réseau diviseur comporte au moins une capacité (43) par rapport à la masse, qui est montée en parallèle à la résistance ohmique parallèle (40),
**en ce que** des parties de fréquence à large bande du signal de mesure passent par les capacités (38, 43), et
**en ce que** des parties de tension continue du signal de mesure passent par les résistances ohmique (35, 40).

8. Système de détection de signaux de mesure selon la revendication 6 ou 7, **caractérisé en ce que**
l'amplificateur à tension continue (16, 50, 64, 65) est relié à la pointe de palpage (14, 60, 61) directement ou par l'intermédiaire d'une résistance ohmique (36).

9. Système de détection de signaux de mesure selon la revendication 6 ou 7, **caractérisé en ce que**
l'amplificateur à tension continue (16, 50, 64, 65) est relié à au moins une résistance ohmique parallèle (40).

10. Système de détection de signaux de mesure selon la revendication 6 ou 7, **caractérisé en ce que**
l'amplificateur à tension continue (16, 50, 75, 65) est relié directement ou par l'intermédiaire d'une résistance ohmique (41) à l'extrémité associée à l'amplificateur à large bande (15, 44) du réseau diviseur.

11. Système de détection de signaux de mesure selon l'une des revendications 3 à 10, **caractérisé en ce que**
l'amplificateur à tension continue (16, 50, 64, 65) comporte un amplificateur opérationnel (46), une résistance ohmique (47) et une capacité (48),
**en ce que** la résistance ohmique (47) et la capacité (48) sont montées entre une entrée inverseuse et une sortie de l'amplificateur opérationnel (46),
**en ce que** l'amplificateur à tension continue (16, 50, 64, 65) est un amplificateur inverseur, et
**en ce que** l'amplificateur à tension continue (16, 50, 64, 65) présente une caractéristique passe-bas.

12. Système de détection de signaux de mesure selon l'une des revendications 1 à 11, **caractérisé en ce que**
le microprocesseur (19) calcule la moyenne du signal à tension continue sur un intervalle de temps déterminé.

13. Système de détection de signaux de mesure selon l'une des revendications 1 à 12, **caractérisé en ce que**
le microprocesseur (19) effectue une correction de valeur de mesure du signal à tension continue.

14. Système de détection de signaux de mesure selon l'une des revendications 1 à 13, **caractérisé en ce que**
la valeur du signal à tension continue numérisée par le au moins un transducteur analogique-numérique (18, 71, 72) règle un facteur d'amplification et/ou un décalage de l'amplificateur à large bande (15, 44) dans le palpeur (10, 62).

15. Système de détection de signaux de mesure selon l'une des revendications 5 à 10, **caractérisé en ce que**
l'appareil de mesure (13) comporte au moins un amplificateur d'entrée (23) et au moins un transducteur analogique-numérique (24),
**en ce que** la première ligne de transmission (17) est reliée au moins un amplificateur d'entrée (23),
**en ce que** l'amplificateur d'entrée (23) est relié au transducteur analogique-numérique (24),
**en ce que** les signaux de mesure à large bande sont amplifiés par l'amplificateur d'entrée (23),
**en ce que** des signaux de mesure à large bande amplifiée sont numérisés par le transducteur analogique-numérique (24),
**en ce que** le transducteur analogique-numérique (18, 71, 72) relié à l'autre ligne de transmission (26, 68, 69) présente une hauteur sensiblement plus petite des étages de quantification que le transducteur analogique-numérique (24) se trouvant dans l'appareil de mesure (13) pour le signal de mesure à large bande, et
**en ce que** le transducteur analogique-numérique (18, 71, 72) relié à l'autre ligne de transmission (26, 68, 69) présente un temps de traitement sensiblement plus grand par valeur de mesure que le transducteur analogique-numérique (24) pour le signal de mesure à large bande.

16. Système de détection de signaux de mesure selon l'une des revendications 5 à 10 ou 15, **caractérisé en ce que**
le système de détection de signaux de mesure comporte deux autres lignes de transmission (68, 69),
**en ce que** le palpeur comporte deux pointes de palpage (60, 61),
**en ce que** le boîtier de connexion (70) comporte deux transducteurs analogiques-numériques (71, 72) pour le signal de mesure à tension continue,
**en ce qu'**un signal différentiel peut être saisi par le palpeur et peut être transmis à l'appareil de mesure (13).
